# EUROPÄISCHE PATENTSCHRIFT

(11) **EP 4 014 257 B1**
(45) Veröffentlichungstag und Bekanntmachung des Hinweises auf die Patenterteilung: **20.09.2023**
(21) Anmeldenummer: 20785906.7
(22) Anmeldetag: 11.08.2020
(51) Int. Cl.: H01L 31/0224, H01L 31/068

(54) **WAFER-SOLARZELLE**
WAFER SOLAR CELL
CELLULE SOLAIRE À BASE DE PLAQUETTE

(30) Priorität: 16.08.2019 DE 102019122125
(43) Veröffentlichungstag der Anmeldung: 22.06.2022
(73) Patentinhaber: Hanwha Q CELLS GmbH, 06766 Bitterfeld-Wolfen (DE)
(72) Erfinder: GEIßLER, Steffen, 06766 Bitterfeld-Wolfen (DE)
(74) Vertreter: adares Patent- und Rechtsanwälte Reininger & Partner GmbB
(86) Internationale Anmeldenummer: PCT/DE2020/100698
(87) Internationale Veröffentlichungsnummer: WO 2021/032246

(56) Entgegenhaltungen:
- WO-A1-2017/026016
- US-A1- 2018 097 135

## Beschreibung

Die Erfindung betrifft eine Wafer-Solarzelle. Insbesondere betrifft die Erfindung eine Wafer-Solarzelle mit einer Mehrzahl auf einer Solarzellenoberfläche angeordneter Fingerelektroden, die sich in einer Erstreckungsrichtung entlang der Solarzellenoberfläche erstrecken und senkrecht zur Erstreckungsrichtung eine Breite aufweisen.

Aus der WO 2017/026016 A1 ist eine Wafer-Solarzelle mit einer Mehrzahl auf einer Solarzellenoberfläche angeordneter Fingerelektroden bekannt, die sich in einer Erstreckungsrichtung entlang der Solarzellenoberfläche erstrecken und senkrecht zur Erstreckungsrichtung eine Breite aufweisen. Dabei kann die Breite der Fingerelektroden entlang ihrer eigenen Länge angepasst sein.

Derartige Fingerelektroden werden üblicherweise mittels eines Siebdruckverfahrens in einem vorbestimmten Layout auf die Solarzellenoberfläche derart aufgebracht, dass sie oftmals auf und/oder in weiteren Strukturen wie zuvor generierten Laserkontaktöffnungen oder selektiven Emittern der Wafer-Solarzelle angeordnet sind. Siebdruckprozesse schwanken jedoch im Verlauf der Standzeit der zum Einsatz kommenden Siebe in ihrer Genauigkeit insbesondere hinsichtlich Layoutverschiebung, -streckung, -verdrehung oder deren Kombination im Sub-Millimeter-Bereich. Beim Aufbringen von Fingerelektroden auf die Solarzellenoberfläche mittels Siebdruckens werden im Verlauf der Drucksieb-Standzeit insbesondere Layoutstreckungen d.h. eine Veränderung in der Größe des Druckbildes beobachtet. Das Siebdruckverfahren sollte jedoch mit Toleranzen im Sub-Millimeterbereich zu dem vorbestimmten Layout führen, damit die Fingerelektroden passgenau mit den darunter befindlichen weiteren Strukturen überlappen, um eine leistungsfähige und kostengünstige Solarzelle zu erhalten.

Um beobachtete Layoutveränderungen beim Siebdruckverfahren zu kompensieren, können verbreiterte Fingerstrukturen eingesetzt werden, die auch bei gewissen Verschiebungen aufgrund der breiteren Dimensionierung einen vollen Überlapp gewährleisten. Dadurch können durch Layoutverschiebung, -verdrehung und/oder -verzerrung bedingte Verluste kompensiert werden. Dies führt jedoch zu vermehrten Abschattungen und dadurch zu einem Leistungsverlust der Wafer-Solarzelle und zu einem erhöhten Verbrauch der kostenintensiven Siebdruckpasten.

Es ist daher eine Aufgabe der Erfindung, eine Wafer-Solarzelle bereitzustellen, die eine verbesserte Effizienz und/oder Leistung aufweist und gleichzeitig einfach und kostengünstig herstellbar ist.

Erfindungsgemäß wird die Aufgabe durch eine Wafer-Solarzelle mit den Merkmalen des Patentanspruchs 1 gelöst. Vorteilhafte Modifikationen und Weiterbildungen sind in den Unteransprüchen angegeben.

Die Erfindung beruht auf dem Grundgedanken, eine den unvermeidlichen Sub-Millimeter-Veränderungen des Siebdruck-Bildes angepasstes Fingerelektrodenstruktur-Design bereitzustellen. Die Erfinder haben festgestellt, dass eine Fehlausrichtung des gedruckten Layouts mit zunehmenden Abstand zum Mittenbereich des Drucksiebes größer wird: Mittig auf der Solarzellenoberfläche angeordnete Fingerelektroden sind nur relativ wenig von der Layoutverzerrung betroffen, während die am Randbereich angeordneten Fingerelektroden am stärksten von der Layoutverzerrung betroffen sind. Anhand dieser durch Prozessschwankungsanalysen gewonnenen Erkenntnisse ist das mittels Siebdrucks erzeugten Layout der Fingerelektroden erfindungsgemäß optimiert.

Die Fingerelektroden weisen daher erfindungsgemäß ausgehend von einem Mittenbereich der Solarzellenoberfläche quer zur Erstreckungsrichtung betrachtet hin zu den Fingerelektroden in Randbereichen der Solarzellenoberfläche eine jeweilige Breite auf, die zunimmt. Dadurch wird die durch den Siebdruck bedingte Layoutverzerrung wie Layoutverschiebung, - streckung, -verdrehung oder deren Kombination kompensiert, ohne, dass die Effizienz der Solarzelle darunter leidet und/oder ohne zu vergrößerten Abschattungsverlusten und dadurch Leistungsverlusten zu führen. Die durch den Siebdruck entstehenden Layoutverzerrungen sind durch die angepassten Fingerelektroden abgedeckt. Insbesondere ist die jeweilige Breite der Fingerelektroden, die in dem Mittebereich angeordnet sind, verringert und ist die jeweilige Breite der Fingerelektroden, die in Randbereichen angeordnet sind, vergrößert bzw. verbreitert. Dadurch tritt kein Effizienzverlust durch Verschattung auf und ein erhöhter Verbrauch an einer zur Erzeugung der Fingerelektroden eingesetzten Paste wird vermieden.

Erfindungsgemäß ist vorgesehen, dass die jeweilige Breite der Fingerelektroden ausgehend von einem Mittenbereich der Solarzellenoberfläche quer zur Erstreckungsrichtung betrachtet hin zu den Fingerelektroden in Randbereichen der Solarzellenoberfläche zunimmt.

Der Mittenbereich ist im Sinne der Erfindung ein Bereich um einen Mittelpunkt der Wafer-Solarzellenoberfläche, der bevorzugt 10% der Solarzellen-Breite und der Solarzellen-Höhe um den Mittelpunkt herum einnimmt. Die Wafer-Solarzelle weist zum Zeitpunkt des Siebdruckes bevorzugt eine viereckige insbesondere quadratische Solarzellenoberfläche auf, wobei die Ecken abgerundet oder angefast sein können.

Der Randbereich ist im Sinne der Erfindung ein Bereich, der ausgehend von einem Rand der Solarzellenoberfläche eine Breite aufweist, die bevorzugt 10% der Solarzellen-Breite beträgt, wobei die Solarzellen-Breite senkrecht zur Erstreckungsrichtung verläuft. Die Solarzellenoberfläche weist üblicherweise zwei Randbereiche auf, die sich parallel zur Erstreckungsrichtung der Fingerelektroden erstrecken und jeweils eine Breite aufweisen, die senkrecht zu dieser Erstreckungsrichtung verläuft. Die Randbereiche erstrecken sich links bzw. rechts von dem jeweiligen Rand parallel zur Erstreckungsrichtung.

Die Fingerelektroden können auf einer Vorder- und/oder Rückseite der Wafer-Solarzelle angeordnet sein. Die Vorderseite der Solarzelle ist eine Seite der Wafer-Solarzelle, auf der Licht direkt einfällt.

In einer bevorzugten Ausführungsform nimmt die jeweilige Breite der Fingerelektroden ausgehend aus dem Mittenbereich der Solarzellenoberfläche hin zu den Randbereichen zwischen 10% und 60%, bevorzugt 15% bis 55%, bevorzugter 20% bis 50% zu. Mit diesen Wertebereichen werden insbesondere eine ausreichende Genauigkeit und/oder Ausrichtung der Fingerelektroden auf den weiteren Strukturen der Wafer-Solarzelle erzielt.

Bevorzugt weist die Breite der im Mittenbereich angeordneten Fingerelektroden eine absolute Breite im Bereich von 100 bis 220 µm, bevorzugt im Bereich von 110 bis 170 µm, bevorzugter 120 bis 160 µm auf. D.h. eine Breite der im Randbereich angeordneten Fingerelektroden liegt im Bereich von 110 bis 160 µm, wenn die Breite der im Mittenbereich angeordneten Fingerelektroden 100 µm beträgt, und variiert im Bereich von 165 bis 240 µm, wenn die Breite der im Mittenbereich angeordneten Fingerelektroden 150 µm beträgt.

In Abhängigkeit des vorbestimmten Layouts kann die Zunahme in der Breite in verschiedenen Varianten, bevorzugt in den vier nachstehenden Varianten, ausgestaltet sein:
In einer bevorzugten Ausführungsform nimmt die jeweilige Breite der Fingerelektroden ausgehend vom Mittenbereich der Solarzellenoberfläche hin zu den Fingerelektroden in den Randbereichen monoton ansteigend zu. D.h., die jeweilige Breite der Fingerelektroden wird ausgehend vom Mittenbereich zum Randbereich immer größer, wobei sie abschnittsweise konstant bleiben kann, wird jedoch nie kleiner. In der monotonen Beziehung bewegen sich die Abmessungen der jeweiligen Breite ausgehend vom Mittenbereich zum Randbereich tendenziell in dieselbe relative Richtung d.h. werden größer, aber nicht zwangsläufig mit einer konstanten Rate. Im Sinne der Erfindung bedeutet "monoton ansteigend", dass die jeweilige Breite der Fingerelektroden ausgehend vom Mittenbereich der Solarzellenoberfläche hin zu den Randbereichen immer größer wird, wobei sie abschnittsweise konstant bleiben und die Zunahme der jeweiligen Breite eine konstante oder inkonstante Rate aufweisen kann.

Alternativ bevorzugt nimmt die jeweilige Breite der Fingerelektroden ausgehend vom Mittenbereich der Solarzellenoberfläche hin zu den Fingerelektroden in den Randbereichen schritt- bzw. stufenweise zu. Bei der schritt- bzw. stufenweisen Zunahme nimmt die jeweilige Breite der Fingerelektroden in Etappen bzw. etappenweise zu.

Weiterhin alternativ bevorzugt nimmt die jeweilige Breite der Fingerelektroden ausgehend vom Mittenbereich der Solarzellenoberfläche hin zu den Fingerelektroden in den Randbereichen linear ansteigend zu. Die linear ansteigende Zunahme der jeweiligen Breite ist durch eine lineare Zunahme der jeweiligen Breiten benachbarter Fingerelektroden über den Parameter des zunehmenden Abstands zur Mitte der Solarzelle modelliert. Diese lineare Zunahme ist mit einer konstanten Rate realisiert. Die linear ansteigende Zunahme der jeweiligen Breite umfasst die monoton ansteigende Zunahme.

Weiterhin alternativ bevorzugt nimmt die jeweilige Breite der Fingerelektroden ausgehend vom Mittenbereich der Solarzellenoberfläche hin zu den Fingerelektroden in den Randbereichen über einen nichtlinearen funktionalen Zusammenhang mit dem Parameter des zunehmenden Abstands zur Mitte der Solarzelle ansteigend zu.

### In einer bevorzugten Ausführungsform ist die jeweilige Breite jeder Fingerelektrode entlang der Erstreckungsrichtung konstant

Alternativ bevorzugt verjüngt sich die jeweilige Breite einer oder mehrerer Fingerelektroden ausgehend von Enden dieser Fingerelektroden entlang der Erstreckungsrichtung hin zur jeweiligen Mitte dieser Fingerelektroden. Dadurch wird eine größere Breite der Fingerelektroden im Bereich ihrer Enden geschaffen. Dadurch kann bei einer Verdrehung des Drucksiebes relativ zur bedruckenden Oberfläche sicher gestellt werden, dass der Überlapp der zu bedeckenden Strukturen auch in den Randbereichen der Fingerelektroden gewährleistet ist. Der obere und der untere Randbereich erstrecken sich jeweils zwischen dem linken Randbereich und dem rechten Randbereich. Sie weisen jeweils eine Breite auf, die parallel zur Erstreckungsrichtung verläuft und die bevorzugt 10% der Solarzellen-Breite beträgt. Die Fingerelektroden erstrecken sich in der Erstreckungsrichtung entlang der Solarzellenoberfläche ausgehend von dem oberen Randbereich zum unteren Randbereich bzw. umgekehrt.

Bevorzugt sind die Fingerelektroden, die im Mittenbereich angeordnet sind, mit einer jeweiligen Breite ausgebildet, die ausgehend von Enden dieser Fingerelektroden entlang der Erstreckungsrichtung hin zur jeweiligen Mitte dieser Fingerelektroden verjüngt.

In einer bevorzugten Ausführungsform verjüngt sich die jeweilige Breite der einen oder mehreren Fingerelektroden ausgehend von den Enden dieser Fingerelektrode in Richtung hin zur jeweiligen Mitte dieser Fingerelektrode monoton absteigend. D.h., die jeweilige Breite der einen oder mehreren Fingerelektroden wird ausgehend von ihren Enden zur Mitte immer kleiner, wobei sie abschnittsweise konstant bleiben kann, wird jedoch nie größer. In dieser monotonen Beziehung bewegt sich die die jeweilige Breite ausgehend von den Enden dieser Fingerelektrode in Richtung hin zur jeweiligen Mitte dieser Fingerelektrode tendenziell in dieselbe relative Richtung, aber nicht zwangsläufig mit einer konstanten Rate.

In einer Weiterbildung der monotonen Abnahme der absoluten Breite der Fingerelektroden verjüngt sich die jeweilige Breite der einen oder mehreren Fingerelektroden ausgehend von den Enden dieser Fingerelektrode in Richtung hin zur jeweiligen Mitte dieser Fingerelektrode schritt- bzw. stufenweise. Bei der schritt- bzw. stufenweisen Abnahme nimmt die jeweilige Breite der Fingerelektroden in Etappen bzw. etappenweise ab.

Besonders bevorzugt verjüngt sich die jeweilige Breite der einen oder mehreren Fingerelektroden ausgehend von den Enden dieser Fingerelektrode in Richtung hin zur jeweiligen Mitte dieser Fingerelektrode linear absteigend. Die linear absteigende Verjüngung ist durch eine lineare Abnahme ausgehend von den Enden dieser Fingerelektrode in Richtung hin zur jeweiligen Mitte dieser Fingerelektrode modelliert, die mit einer konstanten Rate realisiert ist. Weiterhin alternativ bevorzugt verjüngt sich die jeweilige Breite der einen oder mehreren Fingerelektroden ausgehend von den Enden dieser Fingerelektrode in Richtung hin zur jeweiligen Mitte dieser Fingerelektrode nichtlinear absteigend.

Bevorzugt nimmt die jeweilige Breite der einen oder mehreren Fingerelektroden von den Enden hin zur jeweiligen Mitte zwischen 20% bis 50%, bevorzugt zwischen 25 bis 45%, bevorzugter 30% bis 40% ab. Hierbei kann sich die jeweilige Breite der einen oder mehreren Fingerelektroden monoton absteigend, schritt- bzw. stufenweise, linear absteigend oder nichtlinear absteigend verjüngen. Insbesondere ist die Breite der Enden der einen oder mehreren Fingerelektroden zwischen 20% bis 50%, bevorzugt zwischen 25 bis 45%, bevorzugter 30% bis 40% größer als die Breite der Mitte der entsprechenden Fingerelektrode.

In einer bevorzugten Ausführungsform weist die Wafer-Solarzelle einen oder mehrere quer zur Erstreckungsrichtung verlaufende Busbars auf. Bevorzugt verjüngt sich die jeweilige Breite der einen oder mehreren Fingerelektroden ausgehend von den Enden dieser Fingerelektrode in Richtung zur jeweiligen Mitte dieser Fingerelektrode über eine Unterbrechung durch den oder die Busbars.

Bevorzugt sind die Fingerelektroden auf und/oder in Laserkontaktöffnungen angeordnet. Die Laserkontaktöffnungen sind bevorzugt in einem weiteren vorbestimmten Layout in die Solarzellenoberfläche eingebracht. Bei Laserkontaktöffnungen handelt es sich um Öffnungen, die mittels eines Lasers in der Solarzellenoberfläche eingebracht sind. Sie dienen zur Herstellung eines elektrischen Kontakts zwischen den Fingerelektroden und auf einer Seite der Solarzellenoberfläche liegenden Strukturelementen, die der Seite gegenüberliegt, auf der die Fingerelektroden angeordnet sind. Sowohl Laserprozesse als auch Druckprozesse zeigen vor allem über die Standzeit der Drucksiebe Schwankungen in ihrer Positionierungs-Genauigkeit. Die erfindungsgemäße Ausbildung der Fingerelektroden wirkt den damit einher gehenden Nachteilen entgegen.

Bevorzugt ist die Wafer-Solarzelle als PERC (Passivated Emitter and Rear Contact bzw. Passivated Emitter Rear Cell)-Solarzelle ausgebildet. Bei der PERC-Technologie ist eine dielektrische Schicht in den Solarzellenaufbau integriert, die von einem Laser bearbeitet und dadurch mit den Laserkontaktöffnungen versehen wird. Diese dielektrische Schicht reflektiert das Licht in die Solarzelle, das ohne Erzeugung von Ladungsträgern bis zur Rückseite gedrungen ist. Auf diese Weise wird eine weitere Möglichkeit zur Erzeugung von Ladungsträgern gegeben.

In einer bevorzugten Ausführungsform ist die Wafer-Solarzelle als Bifacial-Solarzelle ausgebildet. Eine Bifacial-Solarzelle ist eine Solarzelle, die einfallendes Licht nicht nur über ihre Vorder-, sondern auch über ihre Rückseite nutzen kann. Wenn die Bifacial-Solarzelle in einem Solarmodul eingebaut ist, kann indirektes Licht durch reflektierte Sonnenstrahlen von hinten an die Solarzelle gelangen und von ihr verwertet werden. Auf diese Weise erzielt das Solarmodul einen höheren Wirkungsgrad.

Die Bifacial-Solarzelle weist bevorzugt auf der Rückseite Laserkontaktöffnungen und Fingerelektroden auf. Die Fingerelektroden sind bevorzugt aus Aluminium ausgebildet. Alternativ sind die Fingerelektroden bevorzugt aus Silber ausgebildet.

Zwei bevorzugte Ausführungsbeispiele der Erfindung sind in den Figuren beispielhaft dargestellt und werden nachfolgend näher beschrieben. Es zeigen rein schematisch und nicht maßstabsgerecht:
- Fig. 1: eine Teil-Draufsicht auf eine erfindungsgemäße Wafer-Solarzelle; und
- Fig. 2: eine Draufsicht auf eine weitere erfindungsgemäße Wafer-Solarzelle.

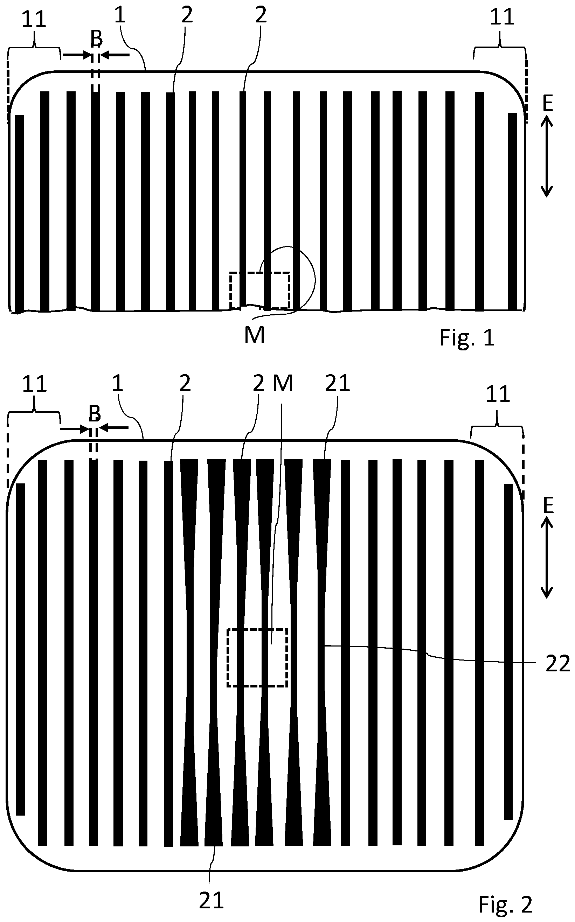

Fig. 1 zeigt eine Teil-Draufsicht auf eine erfindungsgemäße Wafer-Solarzelle. Die Wafer-Solarzelle weist eine Solarzellenoberfläche 1 und eine Mehrzahl an Fingerelektroden 2 auf. Die Fingerelektroden 2 sind auf der Solarzellenoberfläche 1 angeordnet und erstrecken sich parallel zueinander in einer Erstreckungsrichtung E entlang der Solarzellenoberfläche 1. Die Fingerelektroden 2 weisen jeweils senkrecht zur Erstreckungsrichtung E eine Breite B auf, die jeweils entlang der Erstreckungsrichtung E konstant ist. Die jeweilige Breite B der Fingerelektroden 2 nimmt ausgehend von einem Mittenbereich M der Solarzellenoberfläche 1 quer zur Erstreckungsrichtung E betrachtet hin zu den Fingerelektroden 2 in Randbereichen 11 der Solarzellenoberfläche 1 zu.

Der Mittenbereich M ist ein Bereich, der ausgehend von dem Mittelpunkt (nicht gezeigt) der Solarzellenoberfläche 1 10% der Solarzellen-Breite einnimmt. Jeder Randbereich 11 ist ein Bereich, der ausgehend von einem Rand (nicht gezeigt) der Solarzellenoberfläche 1 eine Breite aufweist, die 10% der Solarzellen-Breite beträgt. Die Solarzellenoberfläche 1 weist zwei Ränder auf, die sich parallel zur Erstreckungsrichtung E erstrecken und eine Breite aufweisen, die senkrecht zur Erstreckungsrichtung E verläuft. In der Fig. 1 sind der sich auf einer linken Seite der Solarzellenoberfläche 1 befindende Randbereich 11 und der sich auf einer rechten Seite der Solarzellenoberfläche 1 befindende Randbereich 11 gezeigt.

Fig. 2 zeigt eine Draufsicht auf eine weitere erfindungsgemäße Wafer-Solarzelle. Die in Fig. 2 gezeigte Wafer-Solarzelle entspricht der in Fig. 1 gezeigten Wafer-Solarzelle mit dem Unterscheid, dass sich die jeweilige Breite B mehrerer Fingerelektroden 2 ausgehend von Enden 21 dieser Fingerelektroden 2 entlang der Erstreckungsrichtung E der Fingerelektroden 2 hin zur jeweiligen Mitte 22 dieser Fingerelektroden 2 verjüngt. Die Änderung der absoluten Breite B der Fingerelektroden 2 ist hier übertrieben und nicht maßstabsgerecht gezeigt. Die mehreren sich von ihren Enden 21 zu ihrer Mitte 22 hin verjüngenden Fingerelektroden 2 - rein beispielhaft sechs - sind insbesondere im Mittenbereich M und benachbart dazu und zueinander angeordnet. Bevorzugt sind alle Fingerelektroden 2 mit einer solchen zur jeweiligen Mitte 22 hin verjüngenden Breite B ausgebildet. Diese Variante ist in Figur 2 jedoch nicht dargestellt.

### Bezugszeichenliste:

- B: Breite
- E: Erstreckungsrichtung
- M: Mittenbereich
- 1: Solarzellenoberfläche
- 11: Randbereich
- 2: Fingerelektrode
- 21: Ende
- 22: Mitte

## Patentansprüche

1. Wafer-Solarzelle mit einer Mehrzahl auf einer Solarzellenoberfläche (1) angeordneter Fingerelektroden (2), die sich in einer Erstreckungsrichtung (E) entlang der Solarzellenoberfläche (1) erstrecken und senkrecht zur Erstreckungsrichtung (E) eine Breite (B) aufweisen,
**dadurch gekennzeichnet,**
**dass** die jeweilige Breite (B) der Fingerelektroden (2) ausgehend von einem Mittenbereich (M) der Solarzellenoberfläche (1) quer zur Erstreckungsrichtung (E) betrachtet hin zu den Fingerelektroden (2) in Randbereichen (11) der Solarzellenoberfläche (1) zunimmt.

2. Wafer-Solarzelle nach Anspruch 1, **dadurch gekennzeichnet, dass** die jeweilige Breite (B) der Fingerelektroden (2) ausgehend aus dem Mittenbereich (M) der Solarzellenoberfläche (1) hin zu den Randbereichen (11) zwischen 10% und 60%, bevorzugt 15% bis 55%, bevorzugter 20% bis 50% zunimmt.

3. Wafer-Solarzelle nach Anspruch 1 oder 2, **dadurch gekennzeichnet, dass** die Breite (B) der im Mittenbereich (M) angeordneten Fingerelektroden (2) eine absolute Breite im Bereich von 100 bis 220 µm, bevorzugt im Bereich von 110 bis 170 µm, bevorzugter 120 bis 160 µm aufweist.

4. Wafer-Solarzelle nach einem der vorangehenden Ansprüche, **dadurch gekennzeichnet, dass** die jeweilige Breite (B) der Fingerelektroden (2) ausgehend vom Mittenbereich (M) der Solarzellenoberfläche (1) hin zu den Fingerelektroden (2) in den Randbereichen (11), monoton ansteigend, schritt- bzw. stufenweise ansteigend, linear ansteigend oder nichtlinear ansteigend zunimmt.

5. Wafer-Solarzelle nach einem der vorangehenden Ansprüche, **dadurch gekennzeichnet, dass** die jeweilige Breite (B) jeder Fingerelektrode (2) entlang der Erstreckungsrichtung (E) konstant ist.

6. Wafer-Solarzelle nach einem der vorangehenden Ansprüche 1 bis 4, **dadurch gekennzeichnet, dass** sich die jeweilige Breite (B) einer oder mehrerer Fingerelektroden (2) ausgehend von Enden (21) dieser Fingerelektroden (2) entlang der Erstreckungsrichtung hin zur jeweiligen Mitte (22) dieser Fingerelektroden (2) verjüngt.

7. Wafer-Solarzelle nach Anspruch 6, **dadurch gekennzeichnet, dass** sich die jeweilige Breite (B) der einen oder mehreren Fingerelektroden (2) ausgehend von den Enden (21) dieser Fingerelektrode (2) in Richtung hin zur jeweiligen Mitte (22) dieser Fingerelektrode (2) monoton absteigend, schritt- bzw. stufenweise absteigend, linear absteigend oder nichtlinear absteigend verjüngt.

8. Wafer-Solarzelle nach Anspruch 6 oder 7, **dadurch gekennzeichnet, dass** die jeweilige Breite (B) der einen oder mehreren Fingerelektroden (2) von den Enden (21) hin zur jeweiligen Mitte (22) zwischen 20% bis 50%, bevorzugt zwischen 25 bis 45%, bevorzugter 30% bis 40% abnimmt.

9. Wafer-Solarzelle nach einem der Ansprüche 6 bis 8, **dadurch gekennzeichnet, dass** sie einen oder mehrere quer zur Erstreckungsrichtung (E) verlaufende Busbars aufweist und die jeweilige Breite (B) der einen oder mehreren Fingerelektroden (2) sich ausgehend von den Enden (21) dieser Fingerelektrode (2) in Richtung zur jeweiligen Mitte (22) dieser Fingerelektrode (2) über eine Unterbrechung durch den oder die Busbars verjüngt.

10. Wafer-Solarzelle nach einem der vorangehenden Ansprüche, **dadurch gekennzeichnet, dass** die Fingerelektroden (2) auf und/oder in Laserkontaktöffnungen angeordnet sind.

## Claims

1. A wafer solar cell having a plurality of finger electrodes (2) arranged on a solar cell surface (1), which extend in an extension direction (E) along the solar cell surface (1) and have a width (B) perpendicular to the extension direction (E),
**characterized in that**
the respective width (B) of the finger electrodes (2) increases, starting from a center region (M) of the solar cell surface (1) viewed transversely to the extension direction (E), toward the finger electrodes (2) in edge regions (11) of the solar cell surface (1).

2. The wafer solar cell as claimed in claim 1, **characterized in that** the respective width (B) of the finger electrodes (2) increases, starting from the center region (M) of the solar cell surface (1) toward the edge regions (11), between 10% and 60%, preferably 15% to 55%, more preferably 20% to 50%.

3. The wafer solar cell as claimed in claim 1 or 2, **characterized in that** the width (B) of the finger electrodes (2) arranged in the center region (M) has an absolute width in the range of 100 to 220 µm, preferably in the range of 110 to 170 µm, more preferably 120 to 160 µm.

4. The wafer solar cell as claimed in any one of the preceding claims, **characterized in that** the respective width (B) of the finger electrodes (2) increases, starting from the center region (M) of the solar cell surface (1) toward the finger electrodes (2) in the edge regions (11), monotonously rising, rising in steps or stages, linearly rising, or nonlinearly rising.

5. The wafer solar cell as claimed in any one of the preceding claims, **characterized in that** the respective width (B) of each finger electrode (2) is constant along the extension direction (E).

6. The wafer solar cell as claimed in any one of preceding claims 1 to 4, **characterized in that** the respective width (B) of one or more finger electrodes (2) tapers, starting from ends (21) of these finger electrodes (2) along the extension direction, toward the respective center (22) of these finger electrodes (2).

7. The wafer solar cell as claimed in claim 6, **characterized in that** the respective width (B) of the one or more finger electrodes (2) tapers, starting from the ends (21) of this finger electrode (2) in the direction toward the respective center (22) of this finger electrode (2), monotonously decreasing, decreasing in steps or stages, linearly decreasing, or nonlinearly decreasing.

8. The wafer solar cell as claimed in claim 6 or 7, **characterized in that** the respective width (B) of the one or more finger electrodes (2) decreases from the ends (21) toward the respective center (22) between 20% to 50%, preferably between 25% to 45%, more preferably 30% to 40%.

9. The wafer solar cell as claimed in any one of claims 6 to 8, **characterized in that** it has one or more busbars running transversely to the extension direction (E) and the respective width (B) of the one or more finger electrodes (2) tapers, starting from the ends (21) of this finger electrode (2) in the direction toward the respective center (22) of this finger electrode (2), via an interruption by the busbar or busbars.

10. The wafer solar cell as claimed in any one of the preceding claims, **characterized in that** the finger electrodes (2) are arranged on and/or in laser contact openings.

## Revendications

1. Une cellule solaire wafer avec une pluralité d'électrodes à doigts (2) disposées sur une surface de cellule solaire (1), qui s'étendent dans une direction d'extension (E) le long de la surface de la cellule solaire (1) et ont une largeur (B) perpendiculaire à la direction d'extension (E),
**caractérisée en ce**
**que** la largeur respective (B) des électrodes à doigts (2) augmente en partant d'une région centrale (M) de la surface de la cellule solaire (1) vue transversalement dans la direction de l'extension (E) aux électrodes à doigts (2) dans les régions du bord (11) de la surface de la cellule solaire (1).

2. La cellule solaire wafer selon la revendication 1, **caractérisée en ce que** la largeur respective (B) des électrodes à doigts (2) augmente en partant de la région centrale (M) de la surface de la cellule solaire (1) aux régions du bord (11) entre 10% et 60%, de préférence 15% à 55%, plus préférentiellement 20% à 50%.

3. La cellule solaire wafer selon la revendication 1 ou 2, **caractérisée en ce que** la largeur (B) des électrodes à doigts (2) disposées dans la région centrale (M) présente une largeur absolue comprise entre 100 et 220 µm, de préférence de l'ordre de 110 à 170 µm, plus préférentiellement de 120 à 160 µm.

4. La cellule solaire wafer selon l'une des revendications précédentes, **caractérisée en ce que** la largeur respective (B) des électrodes à doigts (2) augmente en partant de la région centrale (M) de la surface de la cellule solaire (1) aux électrodes à doigt (2) dans les régions du bord (11) de manière croissante monotone, croissante progressivement ou successivement, croissante linéairement ou croissante non linéairement.

5. La cellule solaire wafer selon l'une des revendications précédentes, **caractérisée en ce que** la largeur respective (B) de chaque électrode à doigt (2) est constante le long de la direction de l'extension (E).

6. La cellule solaire wafer selon l'une quelconque des revendications précédentes 1 à 4, **caractérisée en ce que** la largeur respective (B) d'une ou plusieurs électrodes à doigt (2) se rétrécit à partir des extrémités (21) de ces électrodes à doigt (2) le long de la direction d'extension jusqu'au centre respectif (22) de ces électrodes à doigt (2).

7. La cellule solaire wafer selon la revendication 6, **caractérisée en ce que** la largeur respective (B) d'une ou plusieurs électrodes à doigt (2) se rétrécit en partant des extrémités (21) de cette électrode à doigt (2) dans la direction vers le centre respectif (22) de cette électrode à doigt (2) de manière descendante monotone, descendante progressivement ou successivement, descendante linéairement ou descendante non linéairement.

8. La cellule solaire wafer selon la revendication 6 ou 7, **caractérisée en ce que** la largeur respective (B) d'une ou plusieurs électrodes à doigts (2) diminue à partir des extrémités (21) jusqu'au centre respectif (22) entre 20% et 50%, de préférence entre 25 et 45%, plus préférentiellement 30% à 40%.

9. La cellule solaire wafer selon l'une quelconque des revendications 6 à 8, **caractérisée en ce qu'**elle comprend une ou plusieurs barres omnibus allant transversalement dans le sens d'extension (E) et la largeur respective (B) d'une ou plusieurs électrodes à doigt (2) se rétrécit partant des extrémités (21) de cette électrode à doigt (2) dans la direction du centre respectif (22) de cette électrode à doigt (2) via une interruption par la ou les barres omnibus.

10. La cellule solaire wafer selon l'une des revendications précédentes, **caractérisée en ce que** les électrodes à doigt (2) sont disposées sur et/ou dans des ouvertures de contact laser.
